# EUROPEAN PATENT SPECIFICATION

(11) **EP 4 109 518 B1**
(45) Date of publication and mention of the grant of the patent: **29.04.2026**
(21) Application number: 20935562.7
(22) Date of filing: 14.07.2020
(51) Int. Cl.: H10W 76/15, H10W 70/68, H10W 70/692, H10W 40/22, G01S 7/03, H10W 44/20

(54) **THREE-DIMENSIONAL PACKAGING HOUSING STRUCTURE OF RADIO FREQUENCY MICROSYSTEM AND MANUFACTURING METHOD**
DREIDIMENSIONALE GEHÄUSESTRUKTUR FÜR HOCHFREQUENZMIKROSYSTEMVERPACKUNG UND HERSTELLUNGSVERFAHREN
STRUCTURE DE BOÎTIER D'EMBALLAGE TRIDIMENSIONNEL DE MICROSYSTÈME RADIOFRÉQUENCE ET PROCÉDÉ DE FABRICATION

(30) Priority: 13.05.2020 CN 202010401883
(43) Date of publication of application: 28.12.2022
(73) Proprietor: China Electronics Technology Group Corporation No.55 Research Institute, Nanjing, Jiangsu 210016 (CN)
(72) Inventor: PANG, Xueman, Nanjing, Jiangsu 210016 (CN); CHEN, Huanbei, Nanjing, Jiangsu 210016 (CN); LIANG, Qiushi, Nanjing, Jiangsu 210016 (CN)
(74) Representative: Maikowski & Ninnemann Patentanwälte Partnerschaft mbB
(86) International application number: PCT/CN2020/101830
(87) International publication number: WO 2021/227240

(56) References cited:
- CN-A- 101 714 543
- CN-A- 102 738 131
- CN-A- 102 738 131
- CN-A- 108 428 672
- CN-A- 109 103 165
- CN-A- 109 637 980
- US-A1- 2015 131 248
- US-A1- 2017 142 822
- US-B2- 7 262 079

## Description

### TECHNICAL FIELD

The present disclosure relates to a three-dimensional packaging housing structure of a radio frequency microsystem and a manufacturing method, which belong to the field of a packaging for a radio frequency microsystem.

### BACKGROUND

The three-dimensional packaging technology of radio frequency microsystem components is mainly applied in active phased array radar systems. The technical paths for the design and manufacture of radio frequency microsystem components in China and abroad are basically the same. Generally speaking, the radio frequency microsystem components generally have two typical packaging forms. One of the typical packaging forms is PCB matched with metal housing, which is a relatively traditional packaging form with a lower manufacturing difficulty; this type of packaging form is generally large in size, which becomes a bottleneck for the design and production of complex structures, the application of which is limited, and which has few applications at present. The other form is the most commonly used low temperature co-fired ceramic (LTCC) with aluminum-based composite metal housing at present. The LTCC substrate has low dielectric loss and high hardness, which can realize complex wiring requirements and has the conditions to realize multi-channel transmission, which is the most commonly used packaging form of radio frequency microsystem components in China and abroad; the aluminum-based composite metal housing provides signal input and output channels, heat dissipation channels, mechanical support and a protected working environment for the LTCC substrate; this type of packaging form is commonly larger in size, and the packaging of radio frequency microsystem components is realized in the form of AIN substrate, flip-chip monolithic microwave integrated circuit (MMIC), and hair buttons, however, hair buttons require better accurate alignment and assembly, the practicability is not strong, and the reliability is low.

In recent years, more and more attention has been paid to three-dimensional packaging components. It has been reported that the vertical stacking of multi-level LTCC substrates is achieved through the BGA structure of the LTCC substrate itself inside the metal housing. Although this packaging structure reduces the packaging volume to a certain extent, it is necessary to rely on the SMT coaxial type joint to transmit the microwave signals inside the metal housing, resulting in the overall packaging volume of the microsystem is still large; At the same time, the heat dissipation problem between the vertically stacked LTCC substrates is a problem that has always existed in this field; Although the traditional method is to solve the problem of vertical heat dissipation by pouring glue inside the metal housing, due to the lower thermal conductivity of the glue pouring itself, the vertical heat dissipation effect is not ideal.

With the increasingly stringent performance indicators of modern radars, radio frequency microsystem components must develop towards the direction of higher integration and miniaturization. Compared with LTCC technology, high temperature co-fired ceramic (HTCC) technology has higher reliability, lower cost, and can achieve higher integration and miniaturization, and at the same time, the three-dimensional packaging housing of the radio frequency microsystem with vertical heat dissipation channels and multi-layer BGA pad area array structure based on HTCC technology can realize more abundant packaging forms and wider application scenarios, for example, by designing a multi-cavity and multi-channel structure, the metal housing structure can be omitted to achieve further miniaturization of radio frequency microsystem components, and therefore, the HTCC-based three-dimensional packaging technology of radio frequency microsystems will become an important direction for the future development in the field of the microsystem packaging.

US 2017/0142822 A1 describes a wiring substrate that includes: a substrate body made from ceramic, having a front surface and a rear surface, and having a through hole penetrating between the front surface and the rear surface; and a heatsink inserted into the through hole. A step portion protruding in a direction perpendicular to an axial direction of the through hole, is formed over an entire periphery on an inner wall surface of the through hole of the substrate body. A flange opposed to the step portion is provided so as to protrude, over an entire periphery on a side surface of the heatsink. A stress relaxing ring is arranged over an entire periphery between the step portion and a joining surface opposed to the step portion. A brazing material is provided between the ring, and the joining surface and the step portion.

CN 102738131 B discloses a semiconductor packaging structure. The semiconductor packaging structure comprises a base plate, a first chip and a second chip, wherein the base plate comprises a first containing space and a second containing space, the height difference exists between the first containing space and the second containing space, and first guide lines are arranged in the first containing space and the second containing space; the first chip is arranged in the first containing space and is electrically connected with the first guide lines; and the second chip is arranged in the second containing space and is electrically connected with the first guide lines.

US 2015/0131248 A1 describes an electronic module that includes a substrate, which includes a dielectric material having a cavity formed therein. First conductive contacts within the cavity are configured for contact with at least one first electronic component that is mounted in the cavity. Second conductive contacts on a surface of the substrate that surrounds the cavity are configured for contact with at least a second electronic component that is mounted over the cavity. Conductive traces within the substrate are in electrical communication with the first and second conductive contacts.

### SUMMARY

The present invention provides a three-dimensional packaging housing structure of a radio frequency microsystem according to claim 1 and a manufacturing method according to claim 6, which is a three-dimensional packaging housing of a radio frequency microsystem developed on the basis of applying the HTCC technology, which effectively solves the problems existing in the background, and which is a three-dimensional packaging housing structure of the radio frequency microsystem with high-integration, excellent microwave performance and good heat dissipation.

The technical solutions adopted by the present invention to solve the technical problems are the following.

Provided is a three-dimensional packaging housing structure of a radio frequency microsystem, a housing body uses a BGA packaging, the housing body comprises a square housing, the square housing comprises a ceramic base, an inner cavity of the square housing is formed in the ceramic base, and an opening of the inner cavity is not closed.

A welding ring is fixedly arranged on the ceramic base.

A plurality of layers of steps are arranged on four side walls of the inner cavity of the square housing.

Vertical heat dissipation channels are arranged at connecting positions of the steps on the two adjacent sides, the adjacent vertical heat dissipation channels are connected by means of heat dissipation connecting materials.

A horizontal heat dissipation channel is arranged at a center position of a bottom surface of the inner cavity.

A plurality of central metal holes is formed in each layer of the steps, a plurality of metal grounding holes is formed around each central metal hole, and the metal grounding holes are distributed by taking circle centers of the central metal holes as centers.

The central metal holes and the metal grounding holes are covered with pads.

As a further preference of the present invention, the welding ring is fixedly arranged on the ceramic base and connected with the surrounding side walls of the square housing to form a molding.

As a further preference of the present invention, diameters of the central metal holes are in a range of 0.10 mm to 0.15 mm, and diameters of the metal grounding holes are in a range of 0.15 mm to 0.20 mm.

The metal grounding holes comprise at least four metal grounding holes.

The metal grounding holes are distributed by taking the centers of the central metal holes as the circle centers, and radii of annular rings formed by the distribution are in a range of 0.5 mm to 2.0 mm.

As a further preference of the present invention, surface warpages of the steps are less than 1 µm/mm.

As a further preference of the present invention, diameters of the pads are in a range of 0.5 mm to 1.0 mm, and distances between centers of adjacent pads are less than 1.5 mm.

Provided is a method for manufacturing a three-dimensional packaging housing structure of a radio frequency microsystem, a housing body using a BGA packaging, wherein the housing body comprises a square housing, the square housing comprises a ceramic base , an inner cavity of the square housing is formed in the ceramic base, and an opening of the inner cavity is not closed; a welding ring is fixedly arranged on the ceramic base; a plurality of layers of steps are arranged on four side walls of the inner cavity of the square housing; vertical heat dissipation channels are arranged at connecting positions of the steps on two adjacent sides, the adjacent vertical heat dissipation channels are connected by means of heat dissipation connecting materials; a horizontal heat dissipation channel is arranged at a center position of a bottom surface of the inner cavity; a plurality of central metal holes are formed in each layer of the steps, a plurality of metal grounding holes are formed around each central metal hole, and the metal grounding holes are distributed by taking circle centers of the central metal holes as centers; and the central metal holes and the metal grounding holes are covered with pads, the method specifically comprises the following steps.

In Step 1, a ceramic base is prepared by using a process for preparing a ceramic with low-loss in combination with HTCC.

In Step 2, each component is embedded sequentially into a mold with a ceramic base, and the components are assembled through a high temperature brazing to form a prefabrication of a square housing.

In Step 3, a nickel layer and a gold layer are electroplated on a metal area on a surface of the prefabrication of the square housing.

In Step 4, a vertical heat dissipation channels running in a vertical direction and a gold-tin solder sheet are embedded inside the electroplated prefabrication of the square housing to form a housing body after brazing.

In this context, steps of Step 1 specifically comprise the following.

In Step 11, materials are prepared according to a low-loss ceramic formula, then the prepared materials are ball-milled, and a green ceramic tape with a thickness ranging from 0.20 mm to 0.35 mm is flow-cast for a subsequent use.

In Step 12, firstly, the green ceramic tape is sequentially punched holes, filled the holes, printed metallized patterns, punched cavities, laminated and partially laminated by using a HTCC process to form a square housing, a plurality of structures taking centers of the central metal hole as circle centers and having metal grounding holes annularly distributed around the central metal hole are formed in the square housing, then side walls of the square housing are etched by laser to form grooves, the grooves are metallized, integrally-laminated and green-cut, and eventually a ceramic piece of the square housing is formed.

In Step 13, the ceramic piece is pre-sintered according to a process for sintering a ceramic with low loss, and second re-sintering is performed on the ceramic piece after the pre-sintering, wherein a temperature of the pre-sintering is in a range of 1000°C to 1600°C, and a temperature of the second re-sintering is in a range of 1600°C to 1700°C.

In Step 14, nickel is plated on a metal area on a surface of the ceramic piece after the second re-sintering.

As a further preference of the present invention, steps of Step 2 specifically comprise the following.

In Step 21, the ceramic piece after the second re-sintering is embedded into a graphite brazing mold, and a silver-copper solder sheet with a thickness of 0.05 mm is placed at a center position of the square housing; a high thermal conductivity material is covered on the silver-copper solder sheet to form a horizontal heat dissipation channel, and brazing is performed under a hydrogen condition with 790±10°C to form a semi-finished product.

In Step 22, the semi-finished product is embedded into the graphite brazing mold, and a welding ring connected with surrounding side walls of the square housing to form a molding is arranged on a surface of the semi-finished product, and brazing is performed under the hydrogen condition with 790±10°C to form the prefabrication of the square housing, wherein a medium used for brazing is a silver copper solder sheet with a thickness of 0.10 mm.

As a further preference of the present invention, steps of Step 3 specifically comprise the following.

The nickel layer and the gold layer are electroplated on the metal area on the surface of the prefabrication of the square housing, where a thickness of the nickel layer is in a range of 2.5 µm to 6.0 µm, and pads are arranged in the formed center metal holes and the metal grounding holes, where a thickness of the gold layer on a surface of each pad is in a range of 0.1 µm to 0.3 µm and a thickness of a remaining part of the gold layer is in a range of 1.3 µm to 5.7 µm, and eventually a connection wire carrier for plating is removed.

As a further preference of the present invention, steps of Step 4 specifically comprise the following.

The vertical heat dissipation channels in running in the vertical direction are embedded inside the electroplated prefabrication of the square housing, and they are brazed together under a nitrogen condition with 340±10°C to form the square housing, wherein the medium used for brazing is the gold-tin solder sheet with a thickness of 0.05 mm.

Through the above technical solutions, with respect to the prior art, the present invention has the following beneficial effects.
1. The present invention effectively supports the development of traditional radio frequency front-terminal modules from a plane to a board-level 3D structure, and raises the integration to a new level.
2. The present invention establishes a new type of vertical transmission structure in the form of BGA inside the square housing, which satisfies the requirements for the microwave signal transmission of the substrate and the isolation.
3. By arranging a stepped structure in the inner cavity of the square housing, the present invention not only provides a mounting space, but also forms a good vertical heat dissipation channel, which meets the heat dissipation requirements of high-power chips.

### BRIEF DESCRIPTION OF THE DRAWINGS

The present invention will be further described below in combination with the accompanying drawings and embodiments.
FIG. 1 illustrates a schematic diagram of an overall structure according to a preferred embodiment of the present invention.
FIG. 2 illustrates a schematic structural diagram of a semi-finished product according to a preferred embodiment of the present invention.
FIG. 3 illustrates a schematic structural diagram of a prefabrication of a square housing according to a preferred embodiment of the present invention.
FIG. 4 illustrates a schematic diagram of a partial structure after pads are arranged according to a preferred embodiment of the present invention.

In the figures, 1 is a ceramic base; 2 is a horizontal heat dissipation channel; 3 is a welding ring; 4 are central metal holes; 5 are metal grounding holes; 6 are heat dissipation connecting materials; 7 are vertical heat dissipation channels; 8 are pads.

### DETAILED DESCRIPTION OF THE EMBODIMENTS

The present invention will now be described in further detail with reference to the accompanying drawings. These accompanying drawings are all simplified schematic diagrams, and only illustrate the basic structure of the present invention in a schematic manner, so only show the compositions related to the present invention.

The objectives of the present application are to solve the existing problems in the field of three-dimensional packaging of the radio frequency microsystems in the background in terms of integration, microwave performance, heat dissipation, and the like, and to provide a three-dimensional packaging housing structure of a radio frequency microsystem. In the structure, a housing body uses a BGA packaging, the housing body comprises a square housing, the square housing comprises a ceramic base 1, an inner cavity of the square housing is formed in the ceramic base 1, and an opening of the inner cavity is not closed; a welding ring 3 is fixedly arranged on the ceramic base 1; a plurality of layers of steps are arranged on four side walls of the inner cavity of the square housing, surface warpages of the steps are less than 1 µm/mm; vertical heat dissipation channels 7 are arranged at connecting positions of the steps on two adjacent sides; a horizontal heat dissipation channel 2 is arranged at a center position of a bottom surface of the inner cavity; a plurality of central metal holes 4 are formed in each layer of the steps, diameters of the central metal holes 4 are in a range of 0.10 mm to 0.15 mm, a plurality of metal grounding holes 5 are formed around each central metal hole 4, the metal grounding holes comprise at least four and diameters of the metal grounding holes 5 are in a range of 0.15 mm to 0.20 mm, and the metal grounding holes 5 are distributed by taking the centers of the central metal holes 4 as the circle centers, and radii of annular rings formed by the distribution are in a range of 0.5 mm to 2.0 mm; and the central metal holes 4 and the metal grounding holes 5 are covered with pads 8, diameters of the pads 8 are in a range of 0.5 mm to 1.0 mm, and distances between centers of adjacent pads 8 are less than 1.5mm; the welding ring 3 is fixedly arranged on the ceramic base 1, and the welding ring 3 is connected with the surrounding side walls of the square housing to form a molding.

From the perspective of the structure provided in the present application, the use of the BGA transmission structure inside the square housing instead of the SMT coaxial type transmission structure extending outward in the traditional radio frequency module can greatly reduce the size of the radio frequency microsystem packaging, while ensuring the transmission effect of the microwave signals.

Then, a plurality of layers of steps are arranged on the four side walls of the inner cavity of the square housing to establish a vertical transmission structure in the form of steps, which can easily realize the vertical stacking of multi-level substrates inside the square cavity, which not only satisfies the requirements for the microwave signal transmission of the substrates and the isolation, but also achieves the purpose of reducing the plane mounting space and the total packaging volume by increasing the Z-axis stacking and mounting space. This is the first case in the field of packaging housing, which makes the integration of radio frequency microsystems to a new level.

The vertical heat dissipation channels 7 are arranged at connecting positions of the steps on the two adjacent sides; the horizontal heat dissipation channel 2 is arranged at the center position of the bottom surface of the inner cavity; the vertical heat dissipation channel 7 and the horizontal heat dissipation channel 2 are the mounted composite metal heat sinks, the thermal conductivity of which is greatly improved compared with the thermal conductivity of traditional three-dimensional stacking internal glue, which can meet the heat dissipation requirements of tens of watts or even hundreds of watts of power chips, and this is an incomparable advantage of the traditional glue-filling form in realizing vertical heat dissipation.

The method for manufacturing the three-dimensional packaging housing structure of the radio frequency microsystem provided based on the above-mentioned application specifically comprises the following steps.

In Step 1, a ceramic base 1 is prepared by using a process for preparing a ceramic with low loss in combination with HTCC.

Specifically, In Step 11, materials are prepared according to a low-loss ceramic formula, then the prepared materials are ball-milled, and a green ceramic tape with a thickness ranging from 0.20 mm to 0.35 mm is flow-cast for a subsequent use.

The above low-loss ceramic formula is a ratio which is relatively easy to achieve, including alumina, magnesium oxide, calcium oxide and clay, respectively, and the mass ratio of the four components is 92-97:2-5:0.1-3:0.1-3.

In Step 12, firstly, the green ceramic tape is sequentially punched holes, filled the holes, printed metallized patterns, punched cavities, laminated and partially laminated by using a HTCC process to form a square housing, a plurality of structures taking centers of the central metal holes 4 as circle centers and having the metal grounding holes 5 annularly distributed around the central metal holes 4 are formed in the square housing, then side walls of the square housing are etched by laser to form grooves, the grooves are metallized, integrally-laminated and green-cut, and eventually a ceramic piece of the square housing is formed.

In Step 13, the ceramic piece is pre-sintered according to a process for sintering a ceramic with low loss, and second re-sintering is performed on the ceramic piece after the pre-sintering, wherein a temperature of the pre-sintering is in a range of 1000°C to 1600°C and a temperature of the second re-sintering is in a range of 1600°C to 1700°C.

In Step 14, nickel is plated on a metal area on a surface of the ceramic piece after the second re-sintering.

In Step 2, each component is embedded sequentially into a mold with a ceramic base 1, and the components are assembled through a high temperature brazing to form a prefabrication of a square housing.

Specifically, in Step 21, the ceramic piece after the second re-sintering is embedded into a graphite brazing mold, and a silver-copper solder sheet with a thickness of 0.05mm is placed at a center position of the square housing; a high thermal conductivity material is covered on the silver-copper solder sheet to form a horizontal heat dissipation channel 2, and brazing is performed under a hydrogen condition with 790±10°C to form a semi-finished product.

In Step 22, the semi-finished product is embedded into the graphite brazing mold, and a welding ring 3 connected with surrounding side walls of the square housing to form a molding is arranged on a surface of the semi-finished product, and brazing is performed under the hydrogen condition with 790±10°C to form the prefabrication of the square housing, wherein a medium used for brazing is a silver copper solder sheet with a thickness of 0.10 mm.

In Step 3, a nickel layer and a gold layer are electroplated on a metal area on a surface of the prefabrication of the square housing.

Specifically, the nickel layer and the gold layer are electroplated on the metal area on the surface of the prefabrication of square housing, wherein the thickness of the nickel layer is in a range of 2.5 µm to 6.0 µm. The reason for applying the nickel layer is to act as a barrier layer to prevent the metal ions at the bottom from diffusing upwards, thereby playing a better role in preventing the metal ions from diffusing.

Pads 8 are arranged in the formed center metal holes 4 and the metal grounding holes 5, wherein the thickness of the gold layer on the surface of each pad 8 is in a range of 0.1 µm to 0.3 µm and the thickness of the remaining part of the gold layer is in a range of 1.3 µm to 5.7 µm, and eventually the connection wire carrier for plating is removed.

In Step 4, vertical heat dissipation channels 7 running in a vertical direction and a gold-tin solder sheet are embedded inside the electroplated prefabrication of the square housing to form a housing body after brazing.

Specifically, the vertical heat dissipation channels 7 running in the vertical direction are embedded inside the electroplated prefabrication of the square housing, and they are brazed together under a nitrogen condition with 340± 10° C to form the square housing, wherein the medium used for brazing is the gold-tin solder sheet with a thickness of 0.05 mm.

### Embodiments

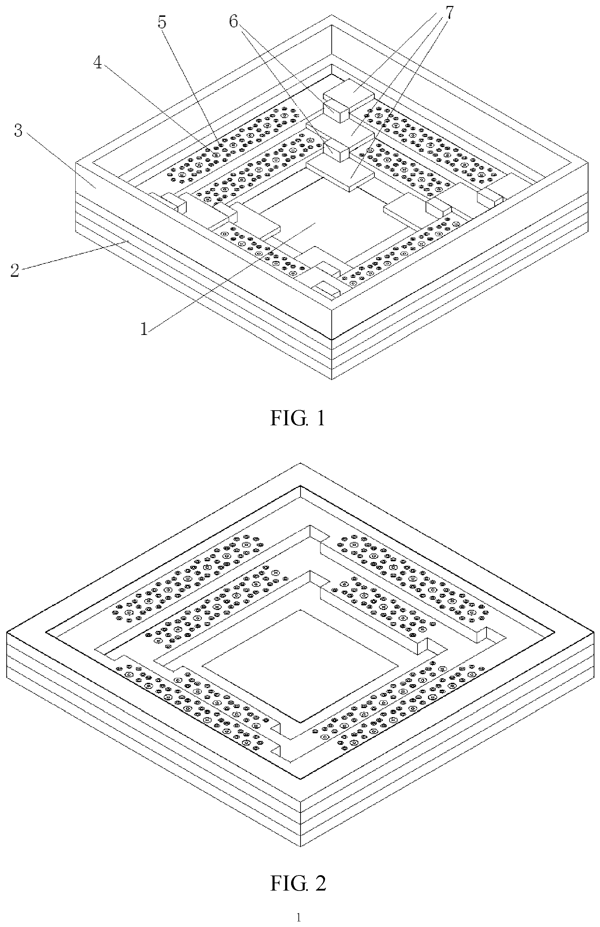

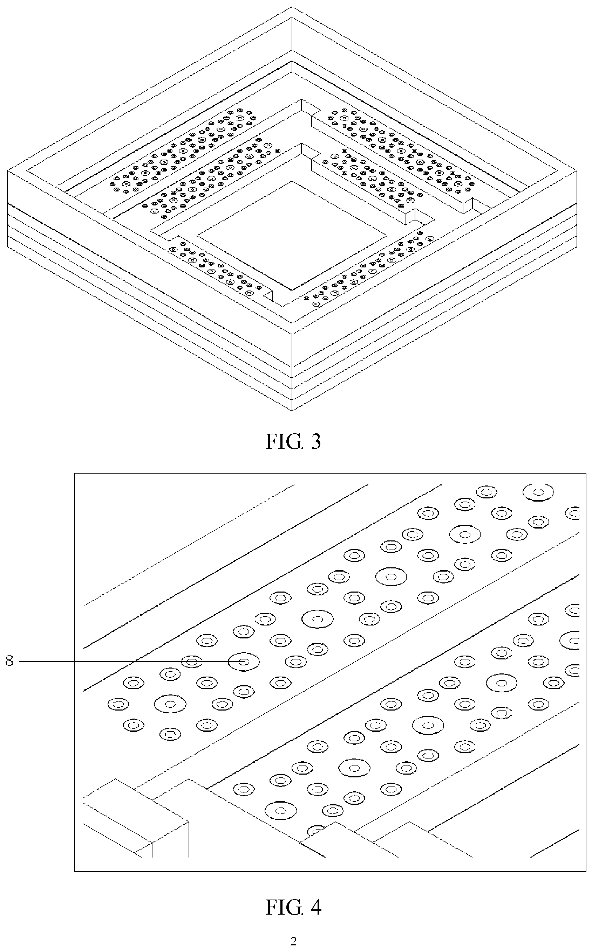

FIG. 1 illustrates a preferred embodiment of a three-dimensional packaging housing structure of a radio frequency microsystem provided by the present application. The housing body is a square housing, according to the dielectric properties of low-loss ceramics, the simulation software is used to calculate the simulated coaxial type microwave signal transmission structure in the required frequency band (25GHz to 35GHz) and the critical sizes of the transmission structure, and then the structure of the entire housing is obtained. As can be seen from FIG. 1, the square housing comprises a ceramic base 1, an inner cavity of the square housing is formed in the ceramic base 1, and an opening of the inner cavity is not closed; a welding ring 3 is fixedly arranged on the ceramic base 1; the simulated coaxial type microwave signal transmission structure is set up in a low-loss ceramic medium, the structure includes two layers of steps arranged on four side walls of the inner cavity of the square housing, vertical heat dissipation channels 7 arranged at the connecting positions of the steps on the two adjacent sides, and a horizontal heat dissipation channel 2 arranged at the center position of the bottom surface of the inner cavity; the structure further includes a plurality of central metal holes 4 formed in each layer of the steps, a plurality of metal grounding holes 5 formed around each central metal hole 4 and distributed by taking circle centers of the central metal holes 4 as centers, and the central metal holes 4 and the metal grounding holes 5 are covered with pads 8 which are as illustrated in FIG. 4.

In the preferred embodiment provided in the present application, diameters of the central metal holes 4 are 0.10 mm, and hole diameters of the metal grounding holes 5 around the central metal holes are 0.17mm, the number of the metal grounding holes 5 around the central metal holes is eight; and the metal grounding holes 5 are evenly distributed on the rings with the center metal holes 4 as the centers and 0.52 mm as the radius. In the area array structure of the BGA pads 8 distributed horizontally on the surface of each layer of steps, the diameters of the pads 8 are 0.5mm, and the distances between the circle centers of the adjacent pads 8 are 1.27 mm.

It should be noted that the BGA pads 8 and the BGA pads 8 on the back surface of the base plate of the square housing are electrically connected with each other through the internal wiring of the ceramic; a horizontal heat dissipation channel 2 is arranged at the center position of the bottom surface of the ceramic base 1, and the horizontal heat dissipation channel 2 is embedding with a copper-molybdenum-copper-copper high thermal conductivity material of an appropriate size on the bottom surface of the ceramic base 1. and the height of the material of the horizontal heat dissipation channel 2 protruding from the back surface of the square housing does not exceed 30 µm; vertical heat dissipation channels 7 are arranged at specific positions on the four side walls of the ceramic base 1, and the specific positions is the connecting positions of the steps on the two adjacent sides, specifically, the vertical heat dissipation channels 7 are embedded with a molybdenum-copper high thermal conductivity material of an appropriate size at specific positions on the side walls of the ceramic; connected heat conduction is realized by welding a heat conductive connection body between the horizontal heat dissipation channel 2 and the vertical heat dissipation channels 7.

The manufacturing method of the above preferred embodiment specifically comprises the following steps.

In Step 1, a ceramic base is prepared by using a process for preparing a ceramic with low loss in combination with HTCC.

Specifically, in Step 11, materials are prepared according to a low-loss ceramic formula, then the prepared materials are ball-milled, and a green ceramic tape with a thickness of 0.20 mm is flow-cast for a subsequent use.

The above low-loss ceramic formula is a ratio which is relatively easy to achieve, including alumina, magnesium oxide, calcium oxide and clay, respectively, and the mass ratio of the four components is 95:2.5:0.5:1.5.

In Step 12, firstly, the green ceramic tape is sequentially punched holes, filled the holes, printed metallized patterns, punched cavities, laminated and partially laminated by using a HTCC (High-temperature co-fired ceramics) process to form a square housing, a plurality of structures taking centers of the central metal holes 4 as the circle centers and having the metal grounding holes 5 annularly distributed around the central metal holes 4 are formed in the square housing, then side walls of the square housing are etched by laser to form grooves, the grooves are metallized, integrally-laminated and green-cut, and eventually a ceramic piece of the square housing is formed.

In Step 13, the ceramic piece is pre-sintered according to a process for sintering a ceramic with low loss, and second re-sintering is performed on the ceramic piece after the pre-sintering, wherein a temperature of the pre-sintering is in a range of 1000°C to 1600°C, and a temperature of the second re-sintering is in a range of 1600°C to 1700°C.

In Step 14, nickel is plated on the metal area on the surface of the ceramic piece after the second re-sintering.

In Step 2, each component is embedded sequentially into a mold with a ceramic base, and the components are assembled through a high temperature brazing to form a prefabrication of a square housing.

Specifically, in Step 21, the ceramic piece after the second re-sintering is embedded into the graphite brazing mold, and a silver-copper solder sheet with a thickness of 0.05 mm is placed at the center position of the square housing; a high thermal conductivity material copper-molybdenum copper-copper (1:1.5:1) is covered on the silver-copper solder sheet to form a horizontal heat dissipation channel 2, and brazing is performed under a hydrogen condition with 790±10°C to form a semi-finished product.

In Step 22, the semi-finished product is embedded into the graphite brazing mold, and a welding ring 3 connected with the surrounding side walls of the square housing to form a molding is arranged on the surface of the semi-finished product, and brazing is performed under the hydrogen condition with 790±10°C to form the prefabrication of the square housing, wherein the medium used for brazing is a silver copper solder sheet with a thickness of 0.10 mm.

In Step 3, a nickel layer and a gold layer are electroplated on a metal area on a surface of the prefabrication of the square housing.

Specifically, the nickel layer and the gold layer are electroplated on the metal area on the surface of the prefabrication of square housing, where the thickness of the nickel layer is in a range of 2.5 µm to 4.0 µm, pads 8 are arranged in the formed center metal holes 4 and metal grounding holes 5, where the thickness of the gold layer on the surface of each pad 8 is in a range of 0.1 µm to 0.3 µm and the thickness of the remaining part of the gold layer is in a range of 1.3 µm to 2.5 µm, and eventually the connection wire carrier for plating is removed.

In Step 4, vertical heat dissipation channels 7 running in a vertical direction and a gold-tin solder sheet are embedded inside the electroplated prefabrication of the square housing to form a housing body after brazing.

Specifically, the vertical heat dissipation channels 7 running in the vertical direction are embedded inside the electroplated prefabrication of the square housing, where the adjacent vertical heat dissipation channels 7 are connected with each other through heat dissipation connection materials 6, and the vertical heat dissipation channels 7 and heat dissipation connection materials 6 are diamond copper materials with gold plated surfaces, which are brazed together under a nitrogen condition with 340 ± 10°C to form the square housing, wherein the medium used for brazing is the gold-tin solder sheet with a thickness of 0.05 mm.

In a preferred embodiment, the inner cavity has two layers of stepped BGA fronts, and heat dissipation channels are set at four corners, which can realize the stacking of two layers of BGA circuit substrates on the two layers of stepped BGA fronts in the inner cavity. The signal transmission between the two layers of circuit substrates is realized by the internal wiring of the ceramic square housing. Through the vertical heat dissipation channels 7 at the four corners of the inner cavity and the heat sinks (horizontal heat dissipation channels 2) on the bottom plate of the ceramic base 1, an effective heat dissipation of the stacked circuit substrates can be achieved, and at the same time, the square housing can be capped by using a parallel sealing welding process and has air tightness, and the helium leak detection rate is ≤5×10⁻³Pa • cm³/s (He).

It would be understood by those of ordinary skill in the art that, unless otherwise defined, all terms (including technical terms and scientific terminology) used herein have the same meaning as commonly understood by those of ordinary skill in the art to which the present application belongs. It should also be understood that terms such as those defined in the general dictionary should be understood to have meanings consistent with their meanings in the context of the prior art and, unless defined as herein, does not interpret in idealistic or overly formal meanings.

The meaning of "and/or" described in the present application means that each of them exists alone or both are included.

The meaning of "connection" described in the present application may be a direct connection between components or an indirect connection between components through other components.

Taking the above ideal embodiments according to the present invention as inspiration, and through the above description, those of ordinary skill in the art would make various changes and modifications without departing from the technical idea of the present invention. The technical scope of the present invention is not limited to the contents in the specification, and the technical scope must be subjected to the scope of the claims.

## Claims

1. A three-dimensional packaging housing structure of a radio frequency microsystem, wherein the housing structure comprises a housing body using a BGA packaging, wherein the housing body comprises a square housing, the square housing comprises a ceramic base (1), an inner cavity of the square housing is formed in the ceramic base (1), and an opening of the inner cavity is not closed;
a welding ring (3) is fixedly arranged on the ceramic base (1);
a plurality of layers are arranged on four side walls of the inner cavity of the square housing forming a plurality of steps;
a vertical heat dissipation channel (7) is arranged on each step at connecting portions of the step at adjacent side walls of the inner cavity, the adjacent vertical heat dissipation channels (7) of each step are connected by means of heat dissipation connecting materials (6);
a horizontal heat dissipation channel (2) is arranged at a center position of a bottom surface of the inner cavity;
a plurality of central metal holes (4) are formed in each layer of the steps, a plurality of metal grounding holes (5) are formed around each central metal hole, and the metal grounding holes (5) are annularly distributed around respective ones of the central metal holes (4), and
the central metal holes (4) and the metal grounding holes (5) are covered with pads (8).

2. The three-dimensional packaging housing structure of the radio frequency microsystem according to claim 1, **characterized in that** the welding ring (3) is fixedly arranged on the ceramic base (1), and connected with the surrounding side walls of the square housing.

3. The three-dimensional packaging housing structure of the radio frequency microsystem according to claim 1, **characterized in that** diameters of the central metal holes (4) are in a range of 0.10 mm to 0.15 mm, and diameters of the metal grounding holes (5) are in a range of 0.15 mm to 0.20 mm;
the metal grounding holes (5) comprise at least four; and
the metal grounding holes (5) are distributed by taking the centers of the central metal holes (4) as the circle centers, and radii of annular rings formed by the distribution are in a range of 0.5 mm to 2.0 mm.

4. The three-dimensional packaging housing structure of the radio frequency microsystem according to claim 1, **characterized in that** surface warpages of the steps are less than 1 µm/mm.

5. The three-dimensional packaging housing structure of the radio frequency microsystem according to claim 1, **characterized in that** diameters of the pads (8) are in a range of 0.5 mm to 1.0 mm, and distances between centers of adjacent pads (8) are less than 1.5 mm.

6. A method for manufacturing a three-dimensional packaging housing structure of a radio frequency microsystem according to claim 1, wherein the method specifically comprises following steps: Step 1, preparing the ceramic base (1) by using a process for preparing a ceramic with low loss in combination with high temperature co-firec ceramic, HTCC;
wherein steps of Step 1 specifically comprise:
Step 11, preparing materials according to a low-loss ceramic formula, then ball-milling the prepared materials, and flow-casting a green ceramic tape with a thickness ranging from 0.20 mm to 0.35 mm for a subsequent use;
Step 12, firstly, sequentially punching holes, filling the holes, printing metallized patterns, punching cavities, laminating and partially laminating, by using a HTCC process, to the green ceramic tape to form a square housing, forming, in the square housing, a plurality of structures taking centers of central metal holes (4) as circle centers and having metal grounding holes (5) annularly distributed around the central metal holes (4), then etching side walls of the square housing by laser to form grooves, metallizing, integrally-laminating and green-cutting the grooves, and eventually forming a ceramic piece of the square housing;
Step 13, pre-sintering the ceramic piece according to a process for sintering a ceramic with low loss, and performing, after the pre-sintering, second re-sintering on the ceramic piece, wherein a temperature of the pre-sintering is in a range of 1000°C to 1600°C and a temperature of the second re-sintering is in a range of 1600°C to 1700°C; and
Step 14, plating nickel on a metal area on a surface of the ceramic piece after the second re-sintering;
Step 2, embedding each component of the ceramic piece sequentially into a mold with the ceramic base (1), and assembling the components through a high temperature brazing to form a prefabrication of the square housing;
Step 3, electroplating a nickel layer and a gold layer on a metal area on a surface of the prefabrication of the square housing; and
Step 4, embedding the vertical heat dissipation channels (7) running in a vertical direction and a gold-tin solder sheet inside the electroplated prefabrication of the square housing to form the housing body after brazing.

7. The method for manufacturing the three-dimensional packaging housing structure of the radio frequency microsystem according to claim 6, wherein steps of Step 2 specifically comprise:
Step 21, embedding the ceramic piece after the second re-sintering into a graphite brazing mold, and placing a silver-copper solder sheet with a thickness of 0.05 mm at a center position of the square housing; covering a high thermal conductivity material on the silver-copper solder sheet to form a horizontal heat dissipation channel (2), and brazing under a hydrogen condition with 790±10°C to form a semi-finished product; and
Step 22, embedding the semi-finished product into the graphite brazing mold, and arranging a welding ring (3) connected with surrounding side walls of the square housing to form a molding on a surface of the semi-finished product, and brazing under the hydrogen condition with 790±10°C to form the prefabrication of the square housing, wherein a medium used for brazing is a silver copper solder sheet with a thickness of 0.10 mm.

8. The method for manufacturing the three-dimensional packaging housing structure of the radio frequency microsystem according to claim 7, **characterized in that** steps of Step 3 specifically comprise:
electroplating the nickel layer and the gold layer on the metal area on the surface of the prefabrication of the square housing, where a thickness of the nickel layer is in a range of 2.5 µm to 6.0 µm, and arranging pads (8) in the formed center metal holes and the metal grounding holes (5), where a thickness of the gold layer on a surface of each pad is in a range of 0.1 µm to 0.3 µm, and a thickness of a remaining part of the gold layer is in a range of 1.3 µm to 5.7 µm, and eventually removing a connection wire carrier for plating.

9. The method for manufacturing the three-dimensional packaging housing structure of the radio frequency microsystem according to claim 8, **characterized in that** steps of Step 4 specifically comprise:
embedding the vertical heat dissipation channels (7) running in the vertical direction inside the electroplated prefabrication of the square housing, and brazing them together under a nitrogen condition with 340±10°C to form the square housing, wherein the medium used for brazing is the gold-tin solder sheet with a thickness of 0.05 mm.

## Patentansprüche

1. Dreidimensionale Gehäusestruktur für ein Hochfrequenz-Mikrosystem, wobei die Gehäusestruktur einen Gehäusekörper in BGA-Bauweise umfasst, wobei der Gehäusekörper ein quadratisches Gehäuse umfasst, wobei das quadratische Gehäuse eine keramische Basis (1) umfasst, ein innerer Hohlraum des quadratischen Gehäuses in der keramischen Basis (1) ausgebildet ist und eine Öffnung des inneren Hohlraums nicht verschlossen ist;
wobei ein Schweißring (3) fest auf der keramischen Basis (1) angeordnet ist;
wobei mehrere Schichten an vier Seitenwänden des inneren Hohlraums des quadratischen Gehäuses angeordnet sind und mehrere Stufen bilden;
wobei auf jeder Stufe an Verbindungsabschnitten der Stufe an benachbarten Seitenwänden des inneren Hohlraums ein vertikaler Wärmeableitungskanal (7) angeordnet ist, wobei die benachbarten vertikalen Wärmeableitungskanäle (7) jeder Stufe mittels Wärmeableitungs-Verbindungsmaterialien (6) miteinander verbunden sind;
wobei an einer mittigen Position einer Bodenfläche des inneren Hohlraums ein horizontaler Wärmeableitungskanal (2) angeordnet ist;
wobei in jeder Schicht der Stufen mehrere zentrale Metalllöcher (4) ausgebildet sind, mehrere Metall-Erdungslöcher (5) um jedes zentrale Metallloch herum ausgebildet sind und die Metall-Erdungslöcher (5) ringförmig um die jeweiligen zentralen Metalllöcher (4) verteilt sind, und
wobei die zentralen Metalllöcher (4) und die Metall-Erdungslöcher (5) mit Pads (8) bedeckt sind.

2. Dreidimensionale Gehäusestruktur für das Hochfrequenz-Mikrosystem nach Anspruch 1, **dadurch gekennzeichnet, dass** der Schweißring (3) fest auf der keramischen Basis (1) angeordnet ist und mit den umliegenden Seitenwänden des quadratischen Gehäuses verbunden ist.

3. Dreidimensionale Gehäusestruktur für das Hochfrequenz-Mikrosystem nach Anspruch 1, **dadurch gekennzeichnet, dass** Durchmesser der zentralen Metalllöcher (4) in einem Bereich von 0,10 mm bis 0,15 mm liegen und Durchmesser der Metall-Erdungslöcher (5) in einem Bereich von 0,15 mm bis 0,20 mm liegen;
wobei die Metall-Erdungslöcher (5) mindestens vier umfassen; und
wobei die Metall-Erdungslöcher (5) mit den Mittelpunkten der zentralen Metalllöcher (4) als Kreismittelpunkte verteilt sind und Radien der durch die Verteilung gebildeten Ringe in einem Bereich von 0,5 mm bis 2,0 mm liegen.

4. Dreidimensionale Gehäusestruktur für das Hochfrequenz-Mikrosystem nach Anspruch 1, **dadurch gekennzeichnet, dass** Oberflächenverwölbungen der Stufen kleiner als 1 µm/mm sind.

5. Dreidimensionale Gehäusestruktur für das Hochfrequenz-Mikrosystem nach Anspruch 1, **dadurch gekennzeichnet, dass** Durchmesser der Pads (8) in einem Bereich von 0,5 mm bis 1,0 mm liegen und Abstände zwischen den Mittelpunkten benachbarter Pads (8) kleiner als 1,5 mm sind.

6. Verfahren zur Herstellung einer dreidimensionalen Gehäusestruktur für ein Hochfrequenz-Mikrosystem nach Anspruch 1,
wobei das Verfahren Im Einzelnen die folgenden Schritte umfasst:
Schritt 1, Herstellen der keramischen Basis (1) unter Verwendung eines Verfahrens zur Herstellung einer verlustarmen Keramik in Kombination mit Hochtemperatur-Kofeuerungskeramik, HTCC;
wobei die Schritte des Schritts 1 im Einzelnen umfassen:
Schritt 11, Herstellen von Materialien gemäß einer verlustarmen Keramikformulierung, anschließendes Kugelmahlen der hergestellten Materialien und Gießen eines ungebrannten Keramikbandes mit einer Dicke im Bereich von 0,20 mm bis 0,35 mm zur späteren Verwendung;
Schritt 12, zunächst sequentielles Lochen, Füllen der Löcher, Drucken metallisierter Muster, Stanzen von Hohlräumen, Laminieren und partielles Laminieren des ungebrannten Keramikbandes unter Verwendung eines HTCC-Verfahrens zur Ausbildung eines quadratischen Gehäuses, Ausbilden einer Mehrzahl von Strukturen in dem quadratischen Gehäuse, bei denen Mittelpunkte zentraler Metalllöcher (4) als Kreismittelpunkte dienen und Metall-Erdungslöcher (5) ringförmig um die zentralen Metalllöcher (4) verteilt sind, anschließendes Ätzen der Seitenwände des quadratischen Gehäuses mittels Laser zur Ausbildung von Nuten, Metallisieren, Ganzlaminieren und Grünbearbeiten der Nuten und schließlich Ausbilden eines Keramikstücks des quadratischen Gehäuses;
Schritt 13, Vorsintern des Keramikstücks gemäß einem Verfahren zum Sintern einer verlustarmen Keramik und, nach dem Vorsintern, Durchführen eines zweiten Nachsinterns des Keramikstücks, wobei eine Temperatur des Vorsinterns in einem Bereich von 1000 °C bis 1600 °C liegt und eine Temperatur des zweiten Nachsinterns in einem Bereich von 1600 °C bis 1700 °C liegt; und
Schritt 14, Vernickeln eines Metallbereichs auf einer Oberfläche des Keramikstücks nach dem zweiten Nachsintern;
Schritt 2, sequentielles Einbetten jeder Komponente des Keramikstücks in eine Form mit der keramischen Basis (1) und Zusammenfügen der Komponenten durch Hochtemperatur-Hartlöten zur Bildung einer Vorfertigung des quadratischen Gehäuses;
Schritt 3, galvanisches Beschichten eines Metallbereichs auf einer Oberfläche der Vorfertigung des quadratischen Gehäuses mit einer Nickelschicht und einer Goldschicht; und
Schritt 4, Einbetten der in vertikaler Richtung verlaufenden vertikalen Wärmeableitungskanäle (7) und einer Gold-Zinn-Lötfolie in die galvanisch beschichtete Vorfertigung des quadratischen Gehäuses, um nach dem Hartlöten den Gehäusekörper auszubilden.

7. Verfahren zur Herstellung der dreidimensionalen für das Hochfrequenz-Mikrosystem nach Anspruch 6, wobei die Schritte des Schritts 2 im Einzelnen umfassen:
Schritt 21, Einbetten des Keramikstücks nach dem zweiten Nachsintern in eine Graphit-Hartlötform und Anordnen einer Silber-Kupfer-Lötfolie mit einer Dicke von 0,05 mm an einer mittigen Position des quadratischen Gehäuses; Bedecken der Silber-Kupfer-Lötfolie mit einem Material mit hoher Wärmeleitfähigkeit zur Ausbildung eines horizontalen Wärmeableitungskanals (2) und Hartlöten unter Wasserstoffbedingungen bei 790±10 °C zur Bildung eines Halbfertigprodukts; und
Schritt 22, Einbetten des Halbfertigprodukts in die Graphit-Hartlötform und Anordnen eines mit umliegenden Seitenwänden des quadratischen Gehäuses verbundenen Schweißrings (3), um eine Formgebung auf einer Oberfläche des Halbfertigprodukts auszubilden, und Hartlöten unter den Wasserstoffbedingungen bei 790±10 °C zur Bildung der Vorfertigung des quadratischen Gehäuses, wobei als Medium für das Hartlöten eine Silber-Kupfer-Lötfolie mit einer Dicke von 0,10 mm verwendet wird.

8. Verfahren zur Herstellung der dreidimensionalen Gehäusestruktur für das Hochfrequenz-Mikrosystem nach Anspruch 7, **dadurch gekennzeichnet, dass** die Schritte des Schritts 3 im Einzelnen umfassen:
galvanisches Beschichten des Metallbereichs auf der Oberfläche der Vorfertigung des quadratischen Gehäuses mit der Nickelschicht und der Goldschicht, wobei eine Dicke der Nickelschicht in einem Bereich von 2,5 µm bis 6,0 µm liegt, und Anordnen von Pads (8) in den ausgebildeten zentralen Metalllöchern und den Metall-Erdungslöchern (5), wobei eine Dicke der Goldschicht auf einer Oberfläche jedes Pads in einem Bereich von 0,1 µm bis 0,3 µm liegt und eine Dicke eines verbleibenden Teils der Goldschicht in einem Bereich von 1,3 µm bis 5,7 µm liegt, und schließlich Entfernen eines Verbindungsdrahtträgers für die Galvanisierung.

9. Verfahren zur Herstellung der dreidimensionalen Gehäusestruktur für das Hochfrequenz-Mikrosystem nach Anspruch 8, **dadurch gekennzeichnet, dass** die Schritte des Schritts 4 im Einzelnen umfassen:
Einbetten der in der vertikalen Richtung verlaufenden vertikalen Wärmeableitungskanäle (7) in die galvanisch beschichtete Vorfertigung des quadratischen Gehäuses und gemeinsames Hartlöten derselben unter Stickstoffbedingungen bei 340±10 °C zur Ausbildung des quadratischen Gehäuses, wobei als Medium für das Hartlöten die Gold-Zinn-Lötfolie mit einer Dicke von 0,05 mm verwendet wird.

## Revendications

1. Structure de boîtier d'encapsulage tridimensionnelle d'un microsystème à radiofréquence, dans laquelle la structure de boîtier comprend un corps de boîtier utilisant un encapsulage BGA, dans laquelle le corps de boîtier comprend un boîtier carré, le boîtier carré comprend une base en céramique (1), une cavité interne du boîtier carré étant formée dans la base en céramique (1), et une ouverture de la cavité interne n'étant pas fermée ;
un anneau de soudage (3) est fixé de manière fixe sur la base en céramique (1) ;
une pluralité de couches sont disposées sur quatre parois latérales de la cavité interne du boîtier carré, formant une pluralité de gradins ;
un canal vertical de dissipation thermique (7) est disposé sur chaque gradin au niveau des parties de raccordement du gradin sur des parois latérales adjacentes de la cavité interne, les canaux verticaux de dissipation thermique (7) adjacents de chaque gradin étant reliés au moyen de matériaux de liaison de dissipation thermique (6) ;
un canal horizontal de dissipation thermique (2) est disposé à une position centrale d'une surface de fond de la cavité interne ;
une pluralité de trous métalliques centraux (4) sont formés dans chaque couche des gradins, une pluralité de trous métalliques de mise à la terre (5) sont formés autour de chaque trou métallique central, et les trous métalliques de mise à la terre (5) sont répartis de manière annulaire autour des trous métalliques centraux (4) respectifs, et
les trous métalliques centraux (4) et les trous métalliques de mise à la terre (5) sont recouverts de pastilles (8).

2. Structure de boîtier d'encapsulage tridimensionnelle du microsystème à radiofréquence selon la revendication 1, **caractérisée en ce que** l'anneau de soudage (3) est fixé de manière fixe sur la base en céramique (1), et relié aux parois latérales environnantes du boîtier carré.

3. Structure de boîtier d'encapsulage tridimensionnelle du microsystème à radiofréquence selon la revendication 1, **caractérisée en ce que** des diamètres des trous métalliques centraux (4) sont compris dans une plage de 0,10 mm à 0,15 mm, et des diamètres des trous métalliques de mise à la terre (5) sont compris dans une plage de 0,15 mm à 0,20 mm ;
les trous métalliques de mise à la terre (5) comprennent au moins quatre ; et
les trous métalliques de mise à la terre (5) sont répartis en prenant les centres des trous métalliques centraux (4) comme les centres de cercle, et les rayons des anneaux formés par la répartition sont compris dans une plage de 0,5 mm à 2,0 mm.

4. Structure de boîtier d'encapsulage tridimensionnelle du microsystème à radiofréquence selon la revendication 1, **caractérisée en ce que** des déformations de surface des gradins sont inférieures à 1 µm/mm.

5. Structure de boîtier d'encapsulage tridimensionnelle du microsystème à radiofréquence selon la revendication 1, **caractérisée en ce que** des diamètres des pastilles (8) sont compris dans une plage de 0,5 mm à 1,0 mm, et les distances entre les centres de pastilles (8) adjacentes sont inférieures à 1,5 mm.

6. Procédé de fabrication d'une structure de boîtier d'encapsulage tridimensionnelle d'un microsystème à radiofréquence selon la revendication 1,
dans lequel le procédé comprend spécifiquement les étapes suivantes :
Étape 1, préparation de la base en céramique (1) en utilisant un procédé de préparation d'une céramique à faible perte en combinaison avec une céramique co-cuite à haute température, HTCC ;
dans lequel les étapes de l'étape 1 comprennent spécifiquement :
Étape 11, préparation de matériaux selon une formule de céramique à faible perte, puis broyage à billes des matériaux préparés, et coulage en bande d'une bande céramique crue d'une épaisseur comprise entre 0,20 mm et 0,35 mm pour une utilisation ultérieure ;
Étape 12, tout d'abord, perforation séquentielle de trous, remplissage des trous, impression de motifs métallisés, poinçonnage de cavités, laminage et laminage partiel, au moyen d'un procédé HTCC, de la bande céramique crue pour former un boîtier carré, formation, dans le boîtier carré, d'une pluralité de structures prenant des centres de trous métalliques centraux (4) comme centres de cercle et ayant des trous métalliques de mise à la terre (5) répartis de manière annulaire autour des trous métalliques centraux (4), puis gravure au laser des parois latérales du boîtier carré pour former des rainures, métallisation, laminage intégral et découpe à l'état cru des rainures, et finalement formation d'une pièce céramique du boîtier carré ;
Étape 13, préfrittage de la pièce céramique selon un procédé de frittage d'une céramique à faible perte, et, après le préfrittage, réalisation d'un second refrittage de la pièce céramique, dans lequel une température du préfrittage est comprise dans une plage de 1000 °C à 1600 °C et une température du second refrittage est comprise dans une plage de 1600 °C à 1700 °C ; et
Étape 14, dépôt de nickel sur une zone métallique d'une surface de la pièce céramique après le second refrittage ;
Étape 2, incorporation séquentielle de chaque composant de la pièce céramique dans un moule avec la base en céramique (1), et assemblage des composants par brasage à haute température afin de former une préfabrication du boîtier carré ;
Étape 3, électrodéposition d'une couche de nickel et d'une couche d'or sur une zone métallique d'une surface de la préfabrication du boîtier carré ; et
Étape 4, incorporation des canaux verticaux de dissipation thermique (7) s'étendant dans une direction verticale et d'une feuille de soudure or-étain à l'intérieur de la préfabrication électrodéposée du boîtier carré pour former le corps de boîtier après brasage.

7. Procédé de fabrication de la structure de boîtier d'encapsulage tridimensionnelle du microsystème à radiofréquence selon la revendication 6, dans lequel des étapes de l'étape 2 comprennent spécifiquement :
Étape 21, incorporation de la pièce céramique après le second refrittage dans un moule de brasage en graphite, et placement d'une feuille de soudure argent-cuivre d'une épaisseur de 0,05 mm à une position centrale du boîtier carré ; recouvrement de la feuille de soudure argent-cuivre par un matériau à haute conductivité thermique afin de former un canal horizontal de dissipation thermique (2), et brasage sous atmosphère d'hydrogène à 790±10 °C pour former un produit semi-fini ; et
Étape 22, incorporation du produit semi-fini dans le moule de brasage en graphite, et disposition d'un anneau de soudage (3) relié aux parois latérales environnantes du boîtier carré pour former un moulage sur une surface du produit semi-fini, et brasage sous l'atmosphère d'hydrogène à 790±10 °C pour former la préfabrication du boîtier carré, dans lequel le milieu utilisé pour le brasage est une feuille de soudure argent-cuivre d'une épaisseur de 0,10 mm.

8. Procédé de fabrication de la structure de boîtier d'encapsulage tridimensionnelle du microsystème à radiofréquence selon la revendication 7, **caractérisé en ce que** les étapes de l'étape 3 comprennent spécifiquement :
l'électrodéposition de la couche de nickel et de la couche d'or sur la zone métallique de la surface de la préfabrication du boîtier carré, où une épaisseur de la couche de nickel est comprise dans une plage de 2,5 µm à 6,0 µm, et la disposition de pastilles (8) dans les trous métalliques centraux formés et les trous métalliques de mise à la terre (5), où une épaisseur de la couche d'or sur une surface de chaque pastille est comprise dans une plage de 0,1 µm à 0,3 µm, et une épaisseur d'une partie restante de la couche d'or est comprise dans une plage de 1,3 µm à 5,7 µm, et, finalement, l'enlèvement d'un support de fil de connexion pour la galvanoplastie.

9. Procédé de fabrication de la structure de boîtier d'encapsulage tridimensionnelle du microsystème à radiofréquence selon la revendication 8, **caractérisé en ce que** les étapes de l'étape 4 comprennent spécifiquement :
l'incorporation des canaux verticaux de dissipation thermique (7) s'étendant dans la direction verticale à l'intérieur de la préfabrication électrodéposée du boîtier carré, et leur brasage conjoint sous un atmosphère d'azote à 340±10 °C pour former le boîtier carré, dans lequel le milieu utilisé pour le brasage est la feuille de soudure or-étain d'une épaisseur de 0,05 mm.
